# EUROPÄISCHE PATENTSCHRIFT

(11) **EP 1 153 183 B1**
(45) Veröffentlichungstag und Bekanntmachung des Hinweises auf die Patenterteilung: **21.04.2004**
(21) Anmeldenummer: 00993423.3
(22) Anmeldetag: 09.12.2000
(51) Int. Cl.: E05B 49/00

(54) **SCHLÜSSEL MIT INTEGRIERTER, ELEKTRONISCHER STEUERSCHALTUNG FÜR EINE KRAFTFAHRZEUG-SICHERHEITSANLAGE**
KEY WITH INTEGRATED, ELECTRONIC CONTROL CIRCUIT FOR A VEHICLE SECURITY SYSTEM
CLEF A CIRCUIT DE COMMANDE ELECTRONIQUE INTEGRE POUR SYSTEME DE SECURITE DE VEHICULE

(30) Priorität: 17.12.1999 DE 19960961
(43) Veröffentlichungstag der Anmeldung: 14.11.2001
(73) Patentinhaber: ROBERT BOSCH GMBH, 70442 Stuttgart (DE)
(72) Erfinder: KAZMIERCZAK, Harald, 71717 Beilstein (DE)
(86) Internationale Anmeldenummer: PCT/DE2000/004380
(87) Internationale Veröffentlichungsnummer: WO 2001/044605

(56) Entgegenhaltungen:
- US-A- 4 200 227
- US-A- 5 337 588

## Beschreibung

### Stand der Technik

Die Erfindung betrifft einen Schlüssel mit integrierter, elektronischer Steuerschaltung für eine Kraftfahrzeug-Sicherheitsanlage, wie Zugangs-, Start- und Fahrberechtigungsanlage, der einen Schlüsselbart und eine Schlüsselhandhabe aus elektrisch leitendem Material aufweist und bei dem die Bauelemente der Steuerschaltung im Bereich der Schlüsselhandhabe angeordnet sind.

Derartige Schlüssel sind z.B. aus der US 5,532,522 bekannt, wobei die Speisung der Steuerschaltung erst beim Einführen in ein speziell ausgebildetes Schloss über ein vom Schloss ausgehendes Magnetfeld erfolgt.

Es ist auch bekannt, die Bauelemente für die in den Schlüssel integrierte Steuerschaltung auf einer Isolier-Trägerplatte, wie Keramik, aufzubringen und zu verdrahten und diese dann im Bereich der Schlüsselhandhabe einzubauen, z.B. in ein Isoliergehäuse einzubetten. Dies erfordert jedoch neben dem Basisteil aus Schlüsselbart und Schlüssellhandhabe ein zusätzliches Bauteil.

Es ist Aufgabe der Erfindung, bei einem Schlüssel der eingangs erwähnten Art den Teile- und Montageaufwand und damit die Herstellkosten zu reduzieren.

Diese Aufgabe wird nach der Erfindung dadurch gelöst, dass die Bauelemente der Steuerung auf ausgestanzten Feldern der Schlüsselhandhabe angeordnet und ihre Anschlüsse über Banddrähte mit aus der Schlüsselhandhabe ausgestanzten Leiterbahnen zur Steuerschaltung miteinander verbunden sind.

Bei dieser Ausgestaltung entfällt die Isolierträgerplatte, die mit den Leiterbahnen zur Verdrahtung auch als Leiterplatte bekannter Art ausgebildet sein könnte, da die Teile der Schlüsselhandhabe deren Funktionen übernehmen und dies allein durch Stanzvorgänge gewonnenen Felder und Leiterbahnen. Der Aufwand für die Verdrahtung der Steuerschaltung wird dadurch jedoch nicht vergrößert.

Der Herstellvorgang des Schlüssels mit der Steuerschaltung wird nach einer Ausgestaltung dadurch erleichtert, dass die Felder und die Leiterbahnen der Schlüsselhandhabe über Trennstege miteinander verbunden sind und in einem ersten Stanzvorgang als Stanzgitter hergestellt sind.

Die aus der Schlüsselhandhabe ausgestanzten Teile bleiben bei der Bestückung und Verdrahtung der Steuerschaltung daher noch in der Endposition gehalten. Ist dazu noch vorgesehen, dass das Stanzgitter auf der einen Seite mit einer Isolierfolie verbunden und auf der anderen Seite mit den Bauelementen bestückt wird, und dass vor oder nach der Bestückung und Verbindung der Bauelemente mit den Leiterbahnen in einem zweiten Stanzvorgang die Trennstege aus dem Stanzgitter entfernt werden, dann erhält die Steuerschaltung erst mit den voneinander getrennten, ausgestanzten Teilen der Schlüsselhandhabe die endgültige Ausgestaltung.

Für den drahtlosen Informationsaustausch zwischen Schlüssel und Schloss kann nach einer Weiterbildung vorgesehen sein, dass der Schlüsselbart und ein Rahmen der Schlüsselhandhabe als Antenne für die Steuerschaltung ausgebildet ist.

Ist die Steuerschaltung in bekannter Weise fremd gespeist, dann kann sie beidseitig in Gehäuseteile aus Isoliermaterial eingebettet, vorzugsweise eingegossen sein.

Nach einer weiteren Ausgestaltung kann jedoch auch vorgesehen sein, dass die Schlüsselhandhabe eine Aufnahme für eine Batterie, wie Knopfzelle, aufweist, dass die Steuerschaltung auf der einen Seite mit der Isolierfolie in ein erstes Gehäuseteil eingegossen ist und dass der Zugang zur Aufnahme für die Batterie auf der gegenüberliegenden Seite der Schlüsselhandhabe über ein zweites abnehmbares Gehäuseteil ermöglicht ist, um die Batterie austauschen zu können.

Vorzugsweise wird der Schlüsselbart und die Schlüsselhandhabe mit den Feldern und Leiterbahnen aus einem kupfergalvanisierten Stahl- oder Messingbasisteil gefertigt, um die nötige Festigkeit und eine gute elektrische Leitfähigkeit für die ausgestanzten Leiterbahnen der Schlüsselhandhabe zu erhalten.

Die Erfindung wird anhand eines in der Zeichnung dargestellten Ausführungsbeispiels näher erläutert. Es zeigen:
- Fig. 1: in Draufsicht ein aus Schlüsselbart und Schlüsselhandhabe vorbereitetes, als Ausgangsteil verwendetes Stanzggitter,
- Fig. 2: den einseitig offenen Schlüssel mit der verdrahteten und betriebsbereiten Steuerschaltung in Draufsicht und
- Fig. 3: den Schlüssel nach Fig. 2 in Seitenansicht.

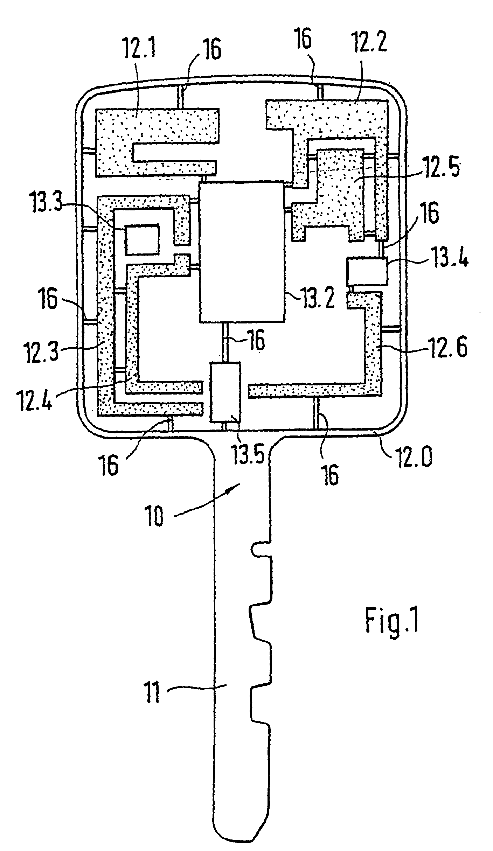

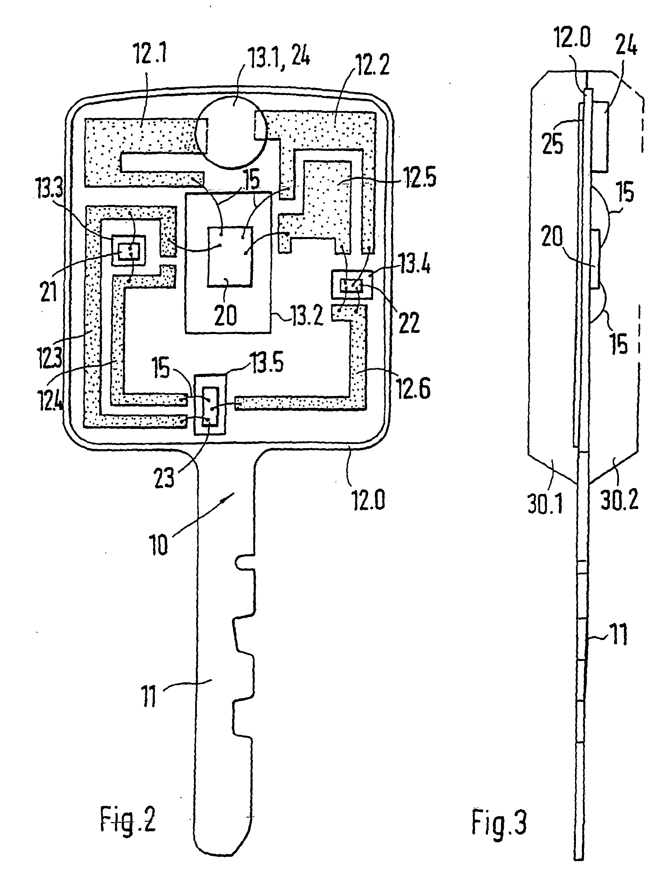

Das Ausgangsteil 10 des Schlüssels nach Fig. 1 ist ein ausgestanztes Stanzgitter aus Schlüsselbart 11 und im Bereich der plattenförmigen Schlüsselhandhabe 12 aus Feldern 20, 21, 22 und 23 und Leiterbahnen 12.1; 12.2; 12.3; 12.4; 12.5 und 12.6, die noch über Trennstege 16 zusammen gehalten sind. Dabei kann ein Rahmen 12.0 um die Schlüsselhandhabe 12 mit dem Schlüsselbart 11 verbunden sein, wie Fig. 2 zeigt, und als Antenne für die Steuerschaltung ausgebildet sein, wenn dieser von den übrigen Teilen der Schlüsselhandhabe getrennt und evtl. mit der Steuerschaltung verbunden ist.

Wie die Fig. 2 zeigt, werden die Bauelemente 20 bis 23 der Steuerschaltung auf ausgestanzten Feldern 13.2; 13.3; 13.4 und 13.5 der Schlüsselhandhabe 12 angeordnet und ihre Anschlüsse über Banddrähte 15 mit den ausgestanzten Leiterbahnen 12.1 bis 12.6 verbunden. Ist die Verdrahtung der Bauelemente 20 bis 23 vollendet, dann werden die Trennstege 16 in einem zweiten Stanzvorgang entfernt. Davor kann das Stanzgitter auf der gegenüberliegenden Seite mit einer Isolierfolie 25 verbunden werden, damit die Felder 13.2 bis 13.5 und die Leiterbahnen 12.1 bis 12.6 auch nach dem zweiten Stanzvorgang ihre Positionen beibehalten und beidseitig in Gehäuseteile 30.1 und 30.2 eingegossen werden können.

Ist eine batteriegespeiste Steuerschaltung in den Schlüssel integriert, dann wird die mit der Steuerschaltung bestückte und verdrahtete Schlüsselhand habe nur auf der Seite mit der Isolierfolie 25 in ein Gehäuse 30.1 eingebettet, z.B. eingegossen. Dabei wird eine Aufnahme 13.1 für eine Knopfzelle 245 als Batterie ausgebildet, in die die Leiterbahnen 12.1 und 12.2 als Anschlüsse für die Knopfzelle 24 ragen. Die andere Seite der Schlüsselhandhabe wird durch ein abnehmbares Gehäuseteil 30.2 abgedeckt, das den Zugang zum Austausch und/oder Aufladen der Knopfzelle 24 ermöglicht. Dieses Gehäuseteil 30.2 kann mittels lösbaren Rastverbindungselementen mit dem Gehäuseteil 30.1 und/oder dem Rahmen 12.0 der verbleibenden Schlüsselhandhabe 12 verbunden werden. Das Ausgangsteil des Schlüssels aus Schlüsselbart 11 und plattenförmiger Schlüsselhandhabe 12 mit den Feldern 13.2 bis 13.5 und den Leiterbahnen 12.1 bis 12.6 zur Herstellung des Stanzgitters nach Fig. 1 besteht aus Stahl oder Messing und ist mit einem Kupfer-Galvanisierüberzug versehen.

## Patentansprüche

1. Schlüssel mit integrierter, elektronischer Steuerschaltung für eine Kraftfahrzeug-Sicherheitsanlage, wie Zugangs-, Start- und Fahrberechtigungsanlage, der einen Schlüsselbart und eine Schlüsselhandhabe aus elektrisch leitendem Material aufweist und bei dem die Bauelemente der Steuerschaltung im Bereich der Schlüsselhandhabe angeordnet sind,
**dadurch gekennzeichnet,**
**dass** die Bauelemente (20, 21, 22, 23) der Steuerung auf ausgestanzten Feldern (13.2; 13.3; 13.4; 13.5) der Schlüsselhandhabe (12) angeordnet und ihre Anschlüsse über Banddrähte (15) mit aus der Schlüsselh andhabe (12) ausgestanzten Leiterbahnen (12.1; 12.2; 12.3; 12.4; 12.5; 12.6) zur Steuerschaltung miteinander verbunden sind.

2. Schlüssel nach Anspruch 1,
**dadurch gekennzeichnet,**
**dass** die Felder (13.2; 13.3; 13.4; 13.5) und die Leiterbahnen (12.1; 12.2; 12.3; 12.4; 12.5; 12.6) der Schlüsselhandhabe (12) über Trennstege (16) miteinander verbunden sind, und in einem ersten Stanzvorgang als Stanzgitter hergestellt sind.

3. Schlüssel nach Anspruch 1 und 2,
**dadurch gekennzeichnet,**
**dass** das Stanzgitter auf der einen Seite mit einer Isolierfolie (25) verbunden und auf der anderen Seite mit den Bauelementen (20, 21, 22, 23) bestückt wird, und
**dass** vor oder nach der Bestückung und Verbindung der Bauelemente (20, 21, 22, 23) mit den Leiterbahnen (12.1; 12.2; 12.3; 12.4; 12.5; 12.6) in einem zweiten Stanzvorgang die Trennstege (16) aus dem Stanzgitter entfernt werden.

4. Schlüssel nach einem der Ansprüche 1 bis 3,
**dadurch gekennzeichnet,**
**dass** der Schlüsselbart (11) und ein Rahmen (12.0) der Schlüsselhandhabe (12) als Antenne für die Steuerschaltung ausgebildet ist.

5. Schlüssel nach einem der Ansprüche 1 bis 4,
**dadurch gekennzeichnet,**
**dass** eine fremd gespeiste Steuerschaltung beidseitig in Gehäuseteile (30.1; 30.2) aus Isoliermaterial eingebettet, vorzugsweise eingegossen ist.

6. Schlüssel nach einem der Ansprüche 1 bis 4,
**dadurch gekennzeichnet,**
**dass** die Schlüsselhandhabe (12) eine Aufnahme (13.1) für eine Batterie, wie Knopfzelle (24), aufweist,
**dass** die Steuerschaltung auf der einen Seite mit der Isolierfolie (25) in ein erstes Gehäuseteil (30.1) eingegossen ist und
**dass** der Zugang zur Aufnahme (13.1) für die Batterie auf der gegenüberliegenden Seite der Schlüsselhandhabe (12) über ein zweites abnehmbares Gehäuseteil (30.2) ermöglicht ist.

7. Schlüssel nach einem der Ansprüche 1 bis 6,
**dadurch gekennzeichnet,**
**dass** der Schlüsselbart (11 ),und die Schlüsselhandhabe (12) mit den Feldern (13.2; 13.3; 13.4; 13.5) und den Leiterbahnen (12.1; 12.2; 12.3; 12.4; 12.5; 12.6) als Stanzgitter aus einem kupfergalvanisierten Stahloder Messingbasisteil gefertigt sind.

## Claims

1. Key with integrated, electronic control circuit for a motor vehicle security system such as an access, starting and driving authorization system, which has a key bit and a key handle made of electrically conductive material, and in which the components of the control circuit are arranged in the region of the key handle, **characterized in that** the components (20, 21, 22, 23) of the controls are arranged on punched-out areas (13.2; 13.3; 13.4; 13.5) of the key handle (12) and their connections to the control circuit via ribbon wires (15) with conductor tracks (12.1; 12.2; 12.3; 12.4; 12.5; 12.6) which are punched out of the key handle (12) are connected to one another.

2. Key according to Claim 1, **characterized in that** the areas (13.2; 13.3; 13.4; 13.5) and the conductor tracks (12.1; 12.2; 12.3; 12.4; 12.5; 12.6) of the key handle (12) are connected to one another via disconnectable webs (16) and are manufactured as punched grilles in a first punching process.

3. Key according to Claims 1 and 2, **characterized in that** the punched grille is connected on one side to an insulating film (25) and is equipped on the other side with the components (20, 21, 22, 23), and **in that**, before and after the equipping and connection of the components (20, 21, 22, 23) to the conductor tracks (12.1; 12.2; 12.3; 12.4; 12.5; 12.6) the disconnectable webs (16) are removed from the punched grille in a second punching process.

4. Key according to one of Claims 1 to 3, **characterized in that** the key bit (11) and a frame (12.0) of the key handle (12) are embodied as an antenna for the control circuit.

5. Key according to one of Claims 1 to 4, **characterized in that** a control circuit which is fed by external means is embedded, preferably cast, on both sides in parts of the housing (30.1; 30.2) which are made of insulating material.

6. Key according to one of Claims 1 to 4, **characterized in that** the key handle (12) has a receptacle (13.1) for a battery such as a button cell (24), **in that** the control circuit is cast on one side with the insulating film (25) in a first part of the housing (30.1), and **in that** the access to the receptacle (13.1) for the battery is made possible on the opposite side of the key handle (12) via a second, removable part of the housing (30.2).

7. Key according to one of Claims 1 to 6, **characterized in that** the key bit (11) and the key handle (12) with the areas (13.2; 13.3; 13.4; 13.5) and the conductor tracks (12.1; 12.2; 12.3; 12.4; 12.5; 12.6) are fabricated as punched grilles from a copper-coated steel or brass base part.

## Revendications

1. Clé a circuit de commande électronique intégré pour système de sécurité de véhicule tel qu'un système d'accès, de démarrage et d'autorisation de conduite, comprenant un panneton et une manette en matériau électriquement conducteur, les composants du circuit de commande étant disposés dans la zone de la manette,
**caractérisée en ce que**
les composants (20, 21, 22, 23) de la commande sont disposés sur des zones découpées (13.2 ; 13.3 ; 13.4 ; 13.5) de la manette (12), et leurs connexions sont reliées les unes aux autres par des fils plats (15) présentant des pistes conductrices (12.1 ; 12.2 ; 12.3 ; 12.4 ; 12.5 ; 12.6) découpées dans la manette (12) pour constituer le circuit de commande.

2. Clé selon la revendication 1,
**caractérisée en ce que**
les zones (13.2 ; 13.3 ; 13.4; 13.5) et les pistes conductrices (12.1 ; 12.2 ; 12.3 ; 12.4 ; 12.5 ; 12.6) de la manette (12) sont reliées les unes aux autres par des nervures de séparation (16) et réalisées sous la forme d'une grille découpée dans une première opération de découpage.

3. Clé selon la revendication 1 et 2,
**caractérisée en ce que**
la grille découpée est reliée sur une face à un film isolant (25) et munie sur l'autre face des composants (20, 21, 22, 23), et avant ou après la mise en place et la mise en liaison des composants (20, 21, 22, 23) avec les pistes conductrices (12.1 ; 12.2 ; 12.3 ; 12.4 ; 12.5 ; 12.6), on supprime les nervures de séparation (16) de la grille découpée dans une deuxième opération de découpage.

4. Clé selon l'une quelconque des revendications 1 à 3,
**caractérisée en ce que**
le panneton (11) et un cadre (12.0) de la manette (12) forment une antenne pour le circuit de commande.

5. Clé selon l'une quelconque des revendications 1 à 4,
**caractérisée en ce qu'**
un circuit de commande à alimentation extérieure est encapsulé, de préférence coulé, de part et d'autre dans des éléments de boîtier (30.1 ; 30.2) en matériau isolant.

6. Clé selon l'une quelconque des revendications 1 à 4,
**caractérisée en ce que**
la manette (12) présente un logement (13.1) pour une pile telle qu'une pile bouton (24), le circuit de commande, par la face présentant le film isolant (25), est coulé dans un premier élément de boîtier (30.1), et l'accès au logement (13.1) pour la pile est rendu possible au niveau de la face opposée de la manette (12) par l'intermédiaire d'un deuxième élément de boîtier (30.2) amovible.

7. Clé selon l'une quelconque des revendications 1 à 6,
**caractérisée en ce que**
le panneton (11) et la manette (12) présentant les zones (13.2 ; 13.3 ; 13.4 ; 13.5) et les pistes conductrices (12.1 ; 12.2 ; 12.3 ; 12.4 ; 12.5 ; 12.6) sont réalisés sous la forme d'une grille découpée à partir d'une pièce de base en laiton ou en acier galvanisé par cuivre.
